Europäisches Patentamt

European Patent Office

Office européen des brevets

(11) Veröffentlichungsnummer: **0 311 957 B1**

## EUROPÄISCHE PATENTSCHRIFT

(12)

(45) Veröffentlichungstag der Patentschrift: **25.03.92**

(21) Anmeldenummer: **88116795.1**

(22) Anmeldetag: **10.10.88**

(51) Int. Cl.⁵: **H02M 7/538**, H03K 17/66

(54) **Verfahren zum querstromfreien Betreiben einer Gegentaktschaltung und Anordnung zur Durchführung des Verfahrens.**

(30) Priorität: **12.10.87 DE 3734500**

(43) Veröffentlichungstag der Anmeldung:
**19.04.89 Patentblatt 89/16**

(45) Bekanntmachung des Hinweises auf die Patenterteilung:
**25.03.92 Patentblatt 92/13**

(84) Benannte Vertragsstaaten:
**DE FR GB IT NL SE**

(56) Entgegenhaltungen:

**PATENT ABSTRACTS OF JAPAN, Band 5, Nr. 179 (E-82)[851], 17. November 1981, Seite 2 & JP-A-56 103 971 (TOKYO SHIBAURA DENKI K.K.) 19-08-1981**

**PATENT ABSTRACTS OF JAPAN, Band 5, Nr. 86 (E-60)[758], 5. Juni 1981, Seite 2 & JP-A-56 34 227 (PIONEER K.K.) 06-04-1981**

(73) Patentinhaber: **SIEMENS AKTIENGESELL-SCHAFT**
**Wittelsbacherplatz 2**
**W-8000 München 2(DE)**

(72) Erfinder: **Lenz, Michael, Dipl.-Ing. (FH)**
**Herzogplatz 5**
**W-8011 Zorneding(DE)**

## Beschreibung

Die Erfindung betrifft ein Verfahren zum querstromfreien Betreiben einer Gegentaktschaltung und eine Anordnung zur Durchführung des Verfahrens nach den Oberbegriffen der Patentansprüche 1 und 3.

Gegentaktschaltungsanordnungen werden vor allem deswegen eingesetzt, weil sie eine große Ausgangsleistung bei gutem Wirkungsgrad ermöglichen. Die mit ihren Ausgangskreisen in Reihe geschalteten komplementären Ausgangstransistoren werden von Gegentaktsignalen angesteuert, die von einem gemeinsamen Eingangssignal abgeleitet sind. Dabei leitet entweder der eine Transistor und der Komplementärtyp sperrt oder umgekehrt. Probleme ergeben sich vor allem beim Übergang vom einen zum anderen Betriebszustand und insbesondere beim Schaltbetrieb dadurch, daß die Schaltzeiten der Transistoren nicht nur vom Typ, sondern auch vor allem von Sättigungseffekten abhängen. Aus physikalischen Gründen schalten nämlich Transistoren grundsätzlich schneller ein als aus.

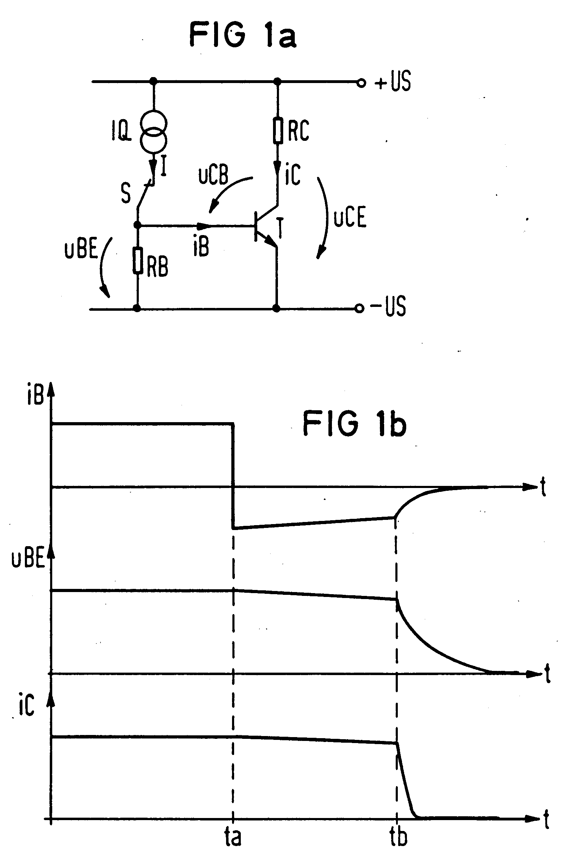

Dieser Sachverhalt ist in FIG 1 der Zeichnung erläutert. Das Ersatzschaltbild gemäß FIG 1a ist über Anschlußklemmen an die Pole +US und -US einer Versorgungsspannungsquelle angeschlossen. Die Stromquelle IQ erzeugt bei geschlossenem Schalter S einen Strom I, der sich aufteilt und einerseits als Basisstrom iB in den Transistor T fließt und andererseits durch den Basiswiderstand RB gegen die negative Versorgungsspannungsklemme -US fließt und am Widerstand RB den Basis-Emitter-Spannungsabfall uBE zur Ansteuerung des Transistors T erzeugt. Der Transistor T ist mit seinem Kollektor über den Kollektorwiderstand RC mit der positiven Versorgungsspannungsquelle +US und mit seinem Emitter direkt mit der negativen Versorgungsspannungsquelle -US verbunden.

In dem Diagramm gemäß FIG 1b ist qualitativ das Ausschalten des Transistors T gezeigt, dessen Basis über den Widerstand RB ausgeräumt wird. Bei einer Öffnung des Schalters S zum Zeitpunkt ta kehrt sich sofort der Basisstrom iB um, weil die in der Basis gespeicherte Ladung abfließt. Der Transistor T verbleibt in der Sättigung bis zum Zeitpunkt tb, an dem die Kollektor-Basis-Spannung uCB Null wird. Ab dem Zeitpunkt tb muß nur noch die Basis-Emitter-Flußkapazität entladen werden. Der Abfall der Basis-Emitter-Spannung uBE erfolgt nach einer Exponentialfunktion. Sobald der von der Basis-Emitter-Spannung uBE abhängige Kollektorstrom iC hinreichend klein ist, kann man den Transistor T als ausgeschaltet betrachten. Hinreichend klein bedeutet, daß der Kollektorstrom so klein sein muß, daß eine Schädigung der Transistoren einer Gegentaktschaltung ausgeschlossen ist. Der Wert für diese Größe ist je nach Anwendungsfall von einem Durchschnittsfachmann festlegbar und kann beispielsweise 10 Prozent des Nennstroms des Transistors betragen. In der Regel ist die Zeit, in der der Transistor T in der Sättigung verbleibt, größer als die Zeit, in der anschließend die Basis-Emitter-Spannung auf einen minimalen Wert abfällt.

In einer Gegentaktschaltung wird nun abwechselnd jeweils einer der beiden komplementären Ausgangstransistoren durchgesteuert oder gesperrt. Am Ausgang der Schaltung, der sich am Verbindungspunkt der Ausgangskreise der beiden komplementären Transistoren befindet, liegt dann abwechselnd die betragsmäßig um die Sättigungsspannung des jeweils leitenden Transistors verminderte Spannung der Versorgungsspannungsquelle +US oder -US.

Bei einem gleichzeitigen Umsteuern der beiden komplementären Transistoren leitet einer der Transistoren bereits voll, bevor aufgrund des anhand von FIG 1 erläuterten Effekts der andere Transistor voll sperrt. In diesem Fall sind beide Ausgangstransistoren leitend und die durch sie hindurchfließenden Ströme steigen bis auf einen Wert an, der nur durch die Stromverstärkung der Ausgangstransistoren begrenzt wird. Dieser zwischen den Anschlußpolen der Versorgungsspannungsquelle fließende Querstrom oder Kreuzleitungsstrom erzeugt sehr hohe Verlustleistungen oder schädigt sogar die Ausgangstransistoren. Vom Zeitpunkt ab, an dem die Basis des in den Sperrzustand gehenden Transistors ausgeräumt ist, fällt der Querstrom ab und die Ausgangsspannung kann den vorgegebenen Wert annehmen.

Bisher vorgeschlagene Lösungen des Problems der Querströme basieren auf dem Grundgedanken, die Ansteuersignale für die kommentären Ausgangstransistoren durch Totzeiten in der Ansteuerung so zu separieren, daß die Leitphasen der Ausgangstransistoren sich nicht überschneiden. Eine derartige Lösung ist in dem Datenblatt der Fa. Silicon General "Linear Integrated Circuits", Juni 1985, Beschreibung des SG 3646, beschrieben. Eine weitere derartige Lösung ist in dem Nachdruck aus Design & Elektronik, Heft Nr. 21, 1986, Aufsatz von Andrew Murray: "Smart Power Treiber-ICs" beschreiben. Beide Lösungen verwenden Totzeiten in der Ansteuerung, die konstant sind und gegebenenfalls für das Ein- und Ausschalten von Transistoren unterschiedlich sein können.

Diese Totzeiten der bekannten Verfahren können beispielsweise aufgrund der endlichen Anstiegszeiten des Eingangssignals mit Hilfe zweier Schmitt-Trigger erzeugt werden, bei denen die Hysteresen ineinander verschachtelt sind. Dabei liegen die Umschaltgrenzen eines Schmitt-Triggers innerhalb der Umschaltgrenzen eines anderen Schmitt-Triggers. Die Ausgangssignale der Schmitt-Trigger werden über logische Gatter miteinander verknüpft und Pufferverstärkern zugeführt, die die komplementären Ausgangstransistoren ansteuern.

Eine andere Möglichkeit zur Erzeugung von Totzeiten besteht darin, die positiven bzw. negativen Flanken der aus dem Eingangssignal abgeleiteten Gegentaktsignale der Schaltungsanordnung unterschiedlich zu verzögern, so daß die negative Steuerflanke immer vor der positiven Flanke über entsprechende Pufferverstärker zur Ansteuerung an die komplementären Ausgangstransistoren gelangt. Diese Lösung ist in dem Datenblatt der Fa. Silicon General verwirklicht.

Die bekannten Lösungen haben den Nachteil, daß die erzeugten Totzeiten unabhängig von der Speicherzeit der Ausgangstransistoren sind. Verlängert sich die Speicherzeit, also die Zeit, in der die Basis-Kollektor-Flußdiodenkapazität entladen und das Basisgebiet des jeweiligen Ausgangstransistors ausgeräumt wird, durch eine Änderung des entsprechenden Ansteuerstroms des Ausgangstransistors, des Lastwiderstands, des Ausräumstroms, der Temperatur oder des Betriebsspannungshubes, oder verkürzt sich die erzeugte Totzeit durch andere Parameteränderungen der Schaltungsanordnung, dann besteht die Gefahr, daß die Speicherzeiten der Ausgangstransistoren größer als die Totzeiten werden und Querströme fließen. Wird andererseits das Sicherheitsverhalten der Schaltung so dimensioniert, daß eine Kollision der Totzeit mit der Speicherzeit in keinem Fall auftreten kann, dann wird die Schaltung aufwendig und unnötig langsam, d.h. für hohe Schaltfrequenzen nicht brauchbar.

Der Erfindung liegt die Aufgabe zugrunde, ein Verfahren und eine Anordnung der eingangs genannten Art anzugeben, bei denen die notwendige Totzeit von zwei aus einem Eingangssignal abgeleiteten Gegentaktsignalen zur Ansteuerung von komplementären Ausgangstransistoren optimal auf das parasitäre Leitungsverhalten der komplementären Ausgangstransistoren abstimmbar ist.

Diese Aufgabe wird bei einem Verfahren und einer Anordnung der eingangs genannten Art erfindungsgemäß durch die Merkmale der kennzeichnenden Teile der Patentansprüche 1 und 3 gelöst.

Das erfindungsgemäße Verfahren und die erfindungsgemäße Schaltungsanordnung besitzen den Vorteil, daß das Gegentaktsignal für den in den leitenden Ausgangszustand zu schaltenden Ausgangstransistor erst dann freigegeben wird, wenn ein für den zu sperrenden Transistor geltendes Sperrkriterium nach einer Prüfung der relevanten Daten des Transistors erfüllt ist. Somit lassen sich die Gegentaktsignale zur Ansteuerung der komplementären Ausgangstransistoren optimal auf die parasitären Leitungseigenschaften der Ausgangstransistoren abstimmen.

Ausgestaltungen des Erfindungsgedankens sind in Unteransprüchen gekennzeichnet.

Die Erfindung wird im folgenden anhand lediglich eines in den Figuren der Zeichnung dargestellten Ausführungsbeispiels näher erläutert. Die Erfindung läßt sich jedoch auch mit gleichem Vorteil auf andere Ausführungsbeispiele anwenden. Es zeigt:

FIG 1 ein Prinzipschaltbild und ein Diagramm zur Erläuterung des prinzipiellen physikalischen Effekt beim Ausschalten eines Transistors,

FIG 2 ein Schemaschaltbild des konkreten Ausführungsbeispiels der Erfindung und

FIG 3 ein Diagramm zur Erläuterung der Funktionsweise der Schaltung gemäß FIG 2.

In den Figuren sind gleiche Elemente mit gleichen Bezugszeichen versehen.

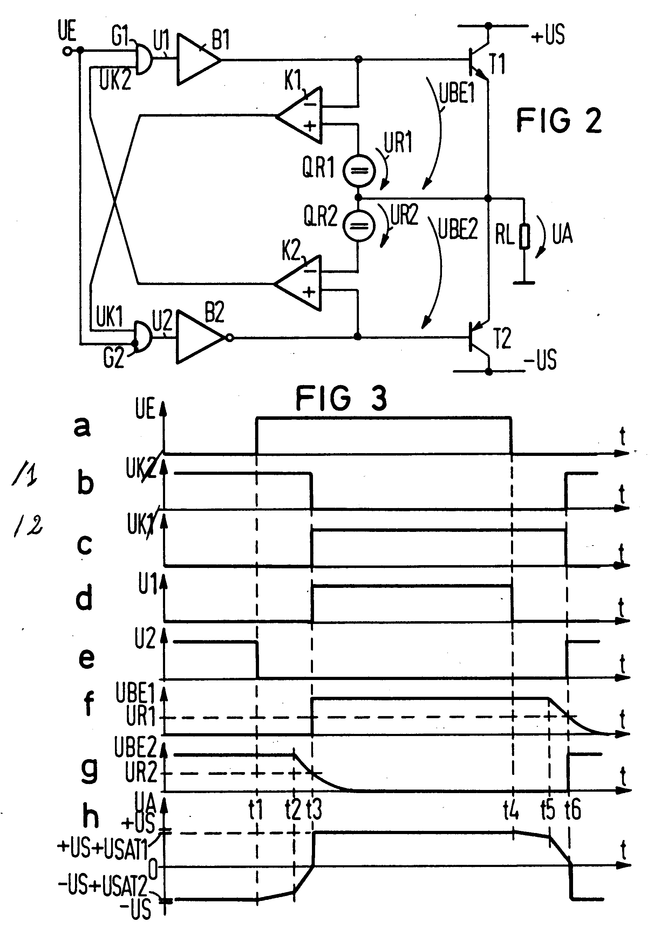

Gemäß FIG 2 wird ein Eingangssignal an der Klemme UE mit Hilfe eines Logikgliedes G1 mit einem Ausgangssignal UK2 eines Komparators K2 verknüpft. Das Ausgangssignal des Logikgliedes G1 dient über einen Pufferverstärker B1 zur Ansteuerung eines npn-Ausgangstransistors T1. Das an der Klemme UE anliegende Eingangssignal wird andererseits invertiert und mit Hilfe eines Logikgliedes G2 mit dem Ausgangssignal UK1 eines Komparators K1 verknüpft. Das Ausgangssignal des Logikgliedes G2 dient unter Zwischenschaltung eines invertierenden Pufferverstärkers B2 zur Ansteuerung eines pnp-Ausgangstransistors T2. Die Logikglieder G1 und G2 sind als UND-Glieder ausgeführt. Die komplementären Ausgangstransistoren T1 und T2 liegen mit ihren Ausgangskreisen in Reihe und zwischen den Anschlüssen +US und -US der Versorgungsspannungsquelle. Der Verbindungspunkt der Ausgangskreise der Transistoren T1 und T2 stellt den Ausgang der Schaltung dar, an den beispielsweise ein Lastwiderstand RL angeschlossen ist. Der Komparator K1 ist an seinem invertierenden Eingang mit der Basis des Transistors T1 und an seinem nicht invertierenden Eingang über eine erste Referenzspannungsquelle QR1 mit dem Ausgang der Schaltung verbunden. Der Komparator K2 ist an seinem nicht invertierenden Eingang mit der Basis des Transistors T2 und an seinem invertierenden Eingang über eine zweite Referenzspannungsquelle QR2 mit dem Ausgang der Schaltung verbunden.

Anstelle zweier komplementärer Ausgangstransistoren kann man auch sich komplementär verhaltende Ausgangstransistoranordnungen verwenden, deren (Leistungs-) Ausgangstransistoren vom selben Typ, z.B. vom npn-Typ, sind und deren die (Lestungs-) Ausgangstransitoren ansteuernden Treibertransistoren vom komplementären Typ sind. Die komplementäre Ausgangstransistoranordnung entspricht dann in ihrem Verhalten komplementären Ausgangstransistoren.

Die erfindungsgemäße Verknüpfung der Gegentaktsignale zur Ansteuerung der komplementären Ausgangstransistoren mit den parasitären Leitungseigenschaften dieser Ausgangstransitoren erfolgt erfindungsgemäß dadurch, daß die Ausgangsströme der Ausgangstransistoren erfaßt und das jeweilige Ansteuerungs-Gegentaktsignal erst freigegeben wird, wenn der Ausgangsstrom des komplementären Ausgangstransistors einen vorgegebenen Minimalwert unterschreitet. Im Ausführungsbeispiel gemäß der FIG 2 dient als Kriterium für den Sperrzustand eines Ausgangstransistors seine Basis-Emitter-Spannung, die gemäß den Erläuterungen zu FIG 1 mit dem Ausgangsstrom des Ausgangstransistors in Beziehung steht.

Gemäß dem Ausführungsbeispiel der FIG 2 werden die Basis-Emitter-Spannungen UBE1 bzw. UBE2 der Ausgangstransistoren T1 bzw. T2 mit Hilfe der Komparatoren K1 bzw. K2 mit von den zugeordneten Referenzspannungsquellen QR1 bzw. QR2 erzeugten Referenzspannungen UR1 bzw. UR2 verglichen. Die Referenzspannungen UR1 bzw. UR2 werden dabei so gewählt, daß sie bei einem Vergleich mit der Basis-Emitter-Spannung des zugeordneten Transistors einem zur Erfüllung des Sperrkriteriums des Transistors hinreichend kleinen Ausgangsstrom entsprechen. Damit ist eine Anpassung der Schaltzeit der Gesamtschaltungsanordnung an die parasitären Leitungseigenschaften der Ausgangstransistoren automatisch erfüllt.

Ist beispielsweise im Ausführungsbeispiel gemäß FIG 2 das Kriterium UBE1 kleiner UR1 erfüllt, also Ausgangstransistor T1 ausgeschaltet, so gibt der Komparator K1 über das Logikglied G2 den unteren Ausgangstransistor T2 frei. Ebenso muß UBE2 erst unter die Referenzspannung UR2 gefallen sein, bis der Ausgangstransistor T1 über das Logikglied G1 eingeschaltet werden kann. Eine Änderung der parasitären Leitungseigenschaften der Ausgangstransistoren wird auf diese Weise erfaßt und kann in keinem Fall zu Querströmen führen.

Das Diagramm gemäß FIG 3 erläutert anhand von Signalen die Funktion der Schaltungsanordnung gemäß FIG 2. Bei einer gemäß FIG 3a positiven Signalflanke des Eingangssignals UE zum Zeitpunkt t1 wird die Ansteuerung des Transistors T2 über das Logikglied G2 und dessen Ausgangsspannung U2 gemäß FIG 3e sofort abgeschaltet. Gemäß den FIG 3g und 3h wird dann die gespeicherte Ladung im Transistor T2 ausgeräumt bis zum Zeitpunkt t2, an dem die Kollektor-Basis-Spannung des Transistors T2 Null ist. Anschliessend wird die Basis-Emitter-Flußkapazität des Transistors entladen. Sobald zum Zeitpunkt t3 der Betrag der Basis-Emitter-Spannung UBE2 des Transistors T2 unter die Referenzspannung UR2 fällt, schaltet der Komparator K2 und gibt gemäß Diagramm 3c die Spannung UK2 ab, so daß über das Logikglied G1 und dessen Ausgangsspannung U1 das Gegentaktsignal für die Ansteuerung des Transistors T1 freigegeben wird. Vor dem Zeitpunkt t1 und nach dem Zeitpunkt t3 liegt die Ausgangsspannung UA über dem Lastwiderstand RL gemäß FIG 3 h auf einem Wert, der betragsmäßig der jeweiligen Versorgungsspannung abzüglich der Sättigungsspannung des gerade leitenden Transistors entspricht, d.h. im Ausführungsbeispiel zwischen -US + USAT2 und + US - USAT1. Bei einer negativen Flankenänderung des Eingangssignals erfolgt der Vorgang gemäß FIG 3 und den Zeitpunkten t4 bis t6 in umgekehrter Richtung.

**Patentansprüche**

1. Verfahren zum querstromfreien Betreiben einer Gegentaktschaltungsanordnung mit zwei in ihren Ausgangskreisen in Reihe geschalteten Ausgangstransistoranordnungen (T1, T2) vom komplementären Typ, die mit Hilfe einer Ansteuerschaltung (G1, B1, K1, G2, B2, K2, UE, QR1, QR2) von zwei Gegentaktsignalen angesteuert werden, die von einem Eingangssignal abgeleitet sind und deren einander zugeordnete Signalflanken zeitlich getrennt hintereinanderfolgen, bei dem die Ausgangsströme der Ausgangstransistoranordnungen (T1, T2) erfaßt werden, **dadurch gekennzeichnet,** daß das jeweilige Ansteuerungs-Gegentaktsignal (U1,U2) für eine Ausgangstransistoranordnung (T1, T2) unverzüglich freigegeben wird, wenn der Ausgangsstrom der komplementären Ausgangstransistoranordnungen (T2, T1) einen vorgegebenen positiven Minimalwert unterschreitet.

2. Verfahren nach Anspruch 1, **dadurch gekennzeichnet,** daß die Basis-Emitter-Spannungen (UBE1, UBE2) der komplementären Ausgangstransistoranordnungen (T1, T2) erfaßt und mit jeweiligen positiven Referenzspannungen (UR1, UR2) verglichen werden.

3. Anordnung zur Durchführung des Verfahrens nach Anspruch 1 oder 2, bei der zur Erfassung der vorgegebenen minimalen Ausgangsströme den Ausgangstransistoranordnungen (T1, T2) Komparatoren (K1, K2) zugeordnet sind, **dadurch gekennzeichnet,** daß die Komparatorausgänge kreuzgekoppelt direkt mit ersten Eingängen logischer Verknüpfungsglieder (G1, G2) verbunden sind, an deren zweiten Eingängen das Eingangs- bzw. invertierte Eingangssignal liegt.

**4.** Anordnung nach Anspruch 3, **dadurch gekennzeichnet,** daß der eine Eingang jedes Komparators (K1, K2) mit der Basis und der andere Eingang jedes Komparators (K1, K2) über eine Referenzspannungsquelle (QR1, QR2) mit dem Emitter der zugeordneten Ausgangstransistoranordnung (T1, T2) verbunden ist.

**5.** Anordnung nach Anspruch 3 oder 4, **dadurch gekennzeichnet,** daß die logischen Verknüpfungsglieder UND-Gatter (G1, G2) sind, denen Pufferverstärker (B1, B2) nachgeschaltet sind.

**Claims**

**1.** Method for the crossover-current-free operation of a push-pull circuit arrangement comprising two output transistor arrangements (T1, T2) of the complementary type which are connected in series in their output circuits and which are driven, with the aid of a drive circuit (G1, B1, K1, G2, B2, K2, UE, QR1, QR2), by two push-pull signals which are derived from one input signal and whose mutually associated signal edges follow one another separated in time, in which the output currents of the output transistor arrangements (T1, T2) are sensed, characterised in that the respective push-pull drive signal (U1, U2) is immediately released for one output transistor arrangement (T1, T2) when the output current of the complementary output transistor arrangements (T2, T1) drops below a predetermined positive minimum value.

**2.** Method according to Claim 1, characterised in that the base-emitter voltages (UBE1, UBE2) of the complementary output transistor arrangements (T1, T2) are sensed and compared with respective positive reference voltages (UR1, UR2).

**3.** Arrangement for carrying out the method according to Claim 1 or 2, in which comparators (K1, K2) are allocated to the output transistor arrangements (T1, T2) for sensing the pre-determined minimum output currents, charac-terised in that the comparator outputs are directly connected cross-coupled to first inputs of logic combining elements (G1, G2), at the second inputs of which the input signal or inverted input signal is present.

**4.** Arrangement according to Claim 3, characterised in that the one input of each comparator (K1, K2) is connected to the base and the other input of each comparator (K1, K2) is connected via a reference voltage source (QR1, QR2) to the emitter of the associated output transistor arrangement (T1, T2).

**5.** Arrangement according to Claim 3 or 4, characterised in that the logic combining elements are AND gates (G1, G2) which are followed by buffer amplifiers (B1, B2).

**Revendications**

**1.** Procédé pour faire fonctionner, sans courant transversal, un montage symétrique comportant deux dispositifs à transistors de sortie (T1,T2) de type complémentaire, dont les circuits d'entrée sont branchés en série et qui sont commandés par un circuit de commande (G1,B1,K1,G2,B2,K2,UE,QR1,QR2) par deux signaux en opposition de phase, qui sont dérivés d'un signal d'entrée et dont les flancs réciproquement associés se succèdent en étant séparés dans le temps, et selon lequel les courants de sortie des dispositifs à transistors de sortie (T1,T2) sont détectés, caractérisé par le fait que le signal de commande en opposition de phase respectif (U1,U2) pour un dispositif à transistors de sortie (T1,T2) est libéré immédiatement lorsque le courant de sortie des dispositifs à transistors de sortie complémentaires (T2,T1) tombe au-dessous d'une valeur minimale positive prédéterminée.

**2.** Procédé suivant la revendication 1, caractérisé par le fait que les tensions base-émetteur (UBE1,UBE2) des dispositifs à transistors de sortie complémentaires (T1,T2) sont détectées et comparées à des tensions de référence positives respectives (UR1,UR2).

**3.** Dispositif pour la mise en oeuvre du procédé suivant la revendication 1 ou 2, dans lequel des comparateurs (K1,K2) sont associés aux dispositifs à transistors de sortie (T1,T2) pour la détection des courants minimum prédéterminés de sortie, caractérisé par le fait que les sorties des comparateurs sont raccordées directement, selon un couplage croisé, à des premières entrées de circuits combinatoires logiques (G1,G2), aux secondes entrées desquels est appliqué le signal d'entrée ou le signal d'entrée inversé.

**4.** Dispositif suivant la revendication 3, caractérisé par le fait qu'une entrée de chaque comparateur (K1,K2) est raccordée à la base et l'autre entrée de chaque comparateur (K1,K2) est raccordée, par l'intermédiaire d'une source de tension de référence (QR1,QR2), à l'émetteur du dispositif à transistors de sortie associé (T1,T2).

5. Dispositif suivant la revendication 3 ou 4, caractérisé par le fait que les circuits combinatoires logiques sont des portes ET (G1,G2), en aval desquelles sont branchés des amplificateurs tampons (B1,B2).

# FIG 1a

# FIG 1b

FIG 2

FIG 3